# EUROPEAN PATENT SPECIFICATION

(11) **EP 0 353 693 B1**
(45) Date of publication and mention of the grant of the patent: **30.11.1994**
(21) Application number: 89114114.5
(22) Date of filing: 31.07.1989
(51) Int. Cl.: H01L 23/31

(54) **Compound semiconductor mesfet device**
MESFET-Anordnung aus Verbindungshalbleiter
Dispositif MESFET en semi-conducteur composé

(30) Priority: 01.08.1988 JP 192286/88
(43) Date of publication of application: 07.02.1990
(73) Proprietor: FUJITSU LIMITED, Kawasaki-shi, Kanagawa 211 (JP)
(72) Inventor: Tatsuta, Shigeru, Atsugi-shi Kanagawa, 243-02 (JP)
(74) Representative: Schmidt-Evers, Jürgen, Dipl.-Ing.

(56) References cited:
- EP-A- 0 178 133
- EP-A- 0 183 550
- GB-A- 2 196 476
- US-A- 4 445 270
- IEEE TRANSACTIONS ON ELECTRONICS DEVICES, vol. ED-31, no. 10, October 1984, pages 1377-1380; P.M. ASBECK et al.: "Piezoelectric effects in GaAs FET's and their role in orientation-dependent device characteristics"

## Description

### BACKGROUND OF THE INVENTION

The present invention generally relates to metal-semiconductor field effect transistors (MESFET) and more particularly to a compound semiconductor MESFET device constructed on a substrate of group III-V compound semiconductor material such as gallium arsenide (GaAs), aluminium gallium arsenide (AlGaAs), indium phosphide (InP) and the like.

Integrated circuits of compound semiconductor MESFET have characteristically high operational speed and are used in various information processing systems such as computers, telecommunication systems, telemetry systems and the like where a particularly high operational speed is strongly demanded. Even in the systems and apparatuses using such integrated circuits, there is a persisting demand to miniaturize the individual devices of the integrated circuit or to increase the integration density so that a still higher operational speed is reached.

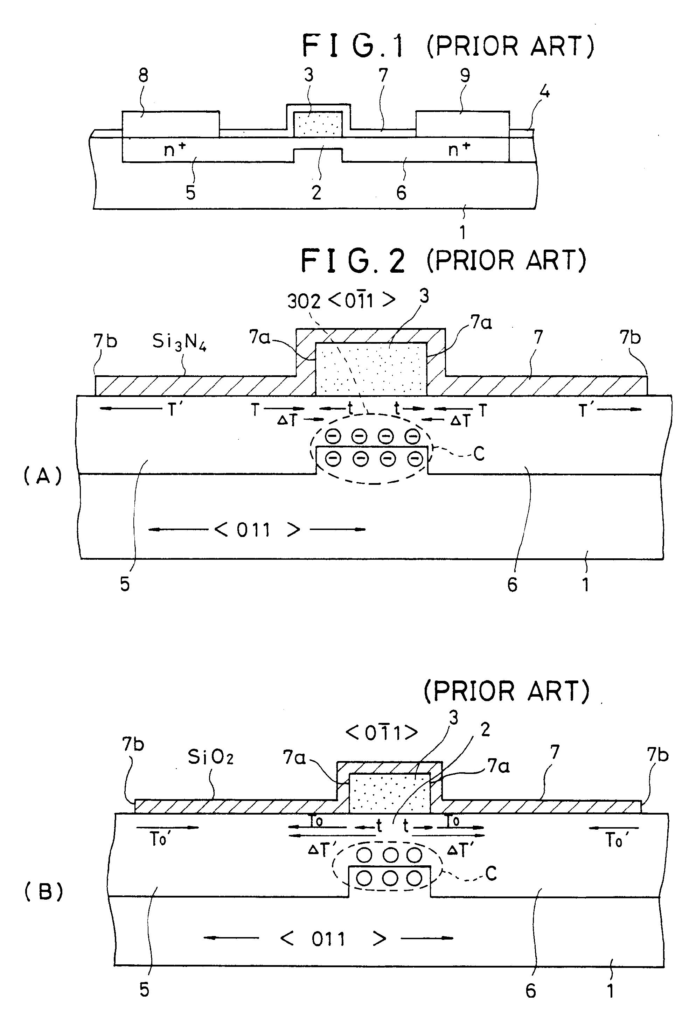

A compound semiconductor MESFET is a device constructed on a group III-V compound semiconductor substrate defined with a channel region together with a source region and a drain region at both sides thereof, in which a gate electrode is provided directly on the substrate in correspondence to the channel region and a passivation film covers the gate electrode as well as the source and drain regions. In such a structure, there appears a complex stress field in the substrate in correspondence to edges of the gate electrode and the passivation film. Such a stress field induces a piezoelectric charge in the substrate and the electrical charge thus induced in the channel region changes the operational speed of the device. In the description hereinafter, the problem of piezoelectric effect which arises in association with the miniaturization of the compound semiconductor MESFET device will be explained with reference to FIGS.1, 2(A) and 2(B) showing a prior art MESFET device having a self-aligned structure known to the inventor. A MESFET of this type is also known from EP-A- 0 178 133.

Referring to FIG.1, the transistor is constructed on a semi-insulating GaAs substrate 1 and comprises an n-type channel region 2 defined in the substrate 1, a gate electrode 3 provided on the substrate 1 in correspondence to the channel region 2, a source region 5 doped to the n⁺-type and defined in the substrate 1 at one side of the channel region 2, a drain region 6 also doped to the n⁺-type and defined in the substrate 1 at the other side of the channel region 2, a source electrode 8 provided on the substrate 1 in correspondence to the source region 5 for making ohmic contact therewith, a drain electrode 9 provided on the substrate 1 in correspondence to the drain region 6 for making ohmic contact therewith, and a passivation film 7 provided so as to cover the gate electrode 3 as well as a part of the substrate 1 extending between the gate electrode 3 and the source electrode 8 or between the gate electrode 3 and the drain electrode 9. Further, the rest of the substrate 1 on which the transistor is not formed is covered by a protective film 4 of silicon nitride. In the illustrated example, the gate electrode 3 is provided on the (100) surface of the GaAs substrate 1 and extends in an <01̅1> direction of the substrate.

When the passivation film 7 is made by silicon nitride, the passivation film 7 is under compressional stress mainly due to the difference in the temperature in which the transistor is fabricated and the temperature in which the transistor is used. Responsive thereto, the substrate 1 experiences a tensile stress T at an inner edge 7a of the passivation film 7 as well as a tensile stress T′ at an outer edge 7b of the passivation film 7 as illustrated in FIG.2(A). For the clarity of the drawing, the source electrode and the drain electrode are omitted in FIG.2(A). Further, the gate electrode 3 itself induces a tensile stress t at the inner edge 7a so as to stretch the substrate. As the tensile stress T acts from both sides of the gate electrode 3 so as to compress a region below the gate electrode 3, and as the magnitude of the tensile stress T is generally much larger than that of the stress t, there appears a compressive stress component ΔT in a region C of the substrate which is slightly below the gate electrode 3 as a result of superposition of the stress T and the stress t. Further, there appears a tensile stress component in the region C as a result of the effect of the stress T′ at the outer edge 7b of the passivation film 7 acting to stretch the substrate in the region C. This tensile stress component is usually negligible as long as the transistor has a relatively large size and there is a relatively large distance between the region C and the edge 7b. Thus, the predominant stress in the region C in this prior art MESFET is compressive.

When a group III-V compound having a zinc blende structure is subjected to such a compressive stress field acting in an <011> direction which is perpendicular to the elongating direction of the gate electrode 3 extending in the <01̅1> direction, there is caused a displacement of the negatively charged arsenic atom relative to the positively charged gallium atom in the substrate and responsive thereto a negative piezoelectrical charge appears in the region C. Such a negative charge in the region C including the channel region 2 induces a stationary depletion region particularly in a lower part of the channel region 2 by expelling the carrier electrons, and responsive thereto the effective channel thickness is decreased and the operational speed of the transistor is increased. Thus, the prior art MESFET of FIG.1 can use this piezoelectrical charge to increase the operational speed of the transistor.

When the size of the transistor is reduced for further improvement of the operational speed, on the other hand, the distance between the outer edge 7b of the passivation film 7 and the gate electrode 3 decreases and the contribution of the tensile stress T′ to the stress field in the region C increases. As a result, there appears a state in which a tensile stress becomes predominant in the region C when the size of the MESFET is made excessively small. In such a state, there appears a positive piezoelectrical charge in the region C and the formation of the depletion region does not occur anymore. Thus, such a miniaturization invites a decrease in the operational speed contrary to the attempt to increase the operational speed of the transistor. More detailed description of the piezoelectric effect in the group III-V compound semiconductor crystals can be found in a paper by Booyens et al. (Booyens, H., Vermaak, J.S., Proto, G.R., "DISLOCATIONS AND THE PIEZOELECTRIC EFFECT IN III-V CRYSTALS", J.Appl.Phys. Vol.48, No.7, July 1977).

FIG.2(B) shows a case in which silicon oxide is used for the passivation film 7. In the drawing, these parts corresponding to those parts in FIG.2(A) are given identical reference numerals and the description thereof will be omitted. It is assumed that the gate electrode 3 extends in the <01̅1> direction on the (100) surface of the gallium arsenide substrate 1 similarly to the case of the transistor of FIG.2(A).

In the transistor of FIG.2(B), the silicon oxide passivation film 7 experiences a tensile stress. In other words, the substrate 1 experiences a compressive stress in the source region 5 and in the drain region 6 and there appears a stress component T₀ at the inner edge 7a of the passivation film 7 acting as a tensile stress to the channel region 2 and a stress component T₀′, at the outer edge 7b of the passivation film 7 acting as a compressional stress to the channel region 2. Further, the tensile stress component t is formed similarly to the case of FIG.2(A) between the gate electrode 3 and the substrate 1. Thus, a large tensile stress component ΔT′ appears in the region C as a sum of the stress components T₀ and t, and the stress component ΔT′ acts in a opposite sense to the stress component ΔT in the case of FIG.2(A). In other words, the stress component ΔT′ acts to deteriorate the operational speed of the transistor.

In this case, the compressional stress component T₀′ at the outer edge 7b of the passivation film compensates the tensile stress component ΔT′ to some extent particularly when the size of the transistor is decreased. However, the effect of the tensile stress component ΔT′ in the region C is generally much larger than the effect of the compressional stress component T₀′ and therefore the undesirable decrease of the operational speed of the transistor cannot be avoided.

### SUMMARY OF THE INVENTION

Accordingly, it is a general object of the present invention to provide a novel and useful compound semiconductor MESFET device wherein the aforementioned problems are eliminated.

Another and more specific object of the present invention is to provide a compound semiconductor MESFET device having a high operational speed by reducing its size.

Another object of the present invention is to provide a compound semiconductor MESFET device comprising a substrate of a group III-V compound semiconductor crystal defined therein with source, channel and drain regions such that the source and drain regions locate at both sides of the channel region, a gate electrode provided on the substrate in correspondence to the channel region and extending in a predetermined elongating direction defined with respect to the crystal orientation of the substrate, a source electrode provided on the substrate in correspondence to the source region with an uncovered region left between the gate electrode and the source electrode, a drain electrode provided on the substrate in correspondence to the drain region with an uncovered region left between the gate electrode and the drain electrode, and a passivation film covering the gate electrode as well as a part of the source and drain regions not covered by the source and drain electrodes, wherein said passivation film has marginal areas, one adjacent to the source electrode and the other adjacent to the drain electrode, both with a modified thickness. According to the present invention, a stress component accumulated in the marginal area of the passivation film and inducing a piezoelectric charge in the channel region which in turn causes undesirable decrease or desirable increase of the operational speed of the MESFET device depending on the elongating direction of the gate electrode and the type of the stress accumulated in the passivation film, is effectively suppressed or enhanced. Thus, by properly modifying the thickness of the marginal area of the passivation film in combination with the material of the passivation film as well as the the elongating direction of the gate electrode, one can reduce an adversary stress component inducing a positive piezoelectric charge in the channel region which in turn causes a decrease in the operational speed of the MESFET. At the same time, one can increase a desirable stress component inducing a negative piezoelectric charge in the channel region which in turn causes an increase in the operational speed of the MESFET.

Other objects and further features of the present invention will become apparent from the following detailed description when read in conjunction with attached drawings.

### BRIEF DESCRIPTION OF THE DRAWINGS

FIG.1 is a cross sectional view showing a typical prior art compound semiconductor field effect transistor;
FIG.2(A) is a cross sectional view showing a stress field developed in the transistor of FIG.1 for a case in which silicon nitride is used for a passivation film of the transistor;
FIG.2(B) is a cross sectional view similar to FIG.2(A) showing the stress field in a case in which silicon oxide is used for the passivation film;
FIG.3 is a cross sectional view showing a first embodiment of the compound semiconductor field effect transistor of the present invention;
FIG.4 is a cross sectional view showing a stress field developed in the transistor of FIG.3;
FIGS.5(A) - (C) are diagrams showing various steps for manufacturing the device of FIG.3;
FIG.6 is a cross sectional view similar to FIG.3 showing a modification of the transistor of FIG.3;
FIG.7 is a cross sectional view similar to FIG.3 showing a second embodiment of the compound semiconductor field effect transistor of the present invention;
FIG.8 is a cross sectional view showing a stress field developed in the substrate of the device of FIG.7;
FIGS.9(A) and (B) are diagrams showing various steps for manufacturing the transistor of FIG.7;
FIG.10 is a cross sectional view showing a modification of the transistor of FIG.7;
FIG.11 is a cross sectional view showing a manufacturing step of the device of FIG.10;
FIG.12 is a cross sectional view showing a third embodiment of the MESFET device of the present invention;
FIG.13 is a cross sectional view showing a stress field developed in the device of FIG.12;
FIG.14 is a cross sectional view showing a fourth embodiment of the MESFET device of the present invention; and
FIG.15 is a cross sectional view showing a stress field developed in the device of FIG.14.

### DETAILED DESCRIPTION

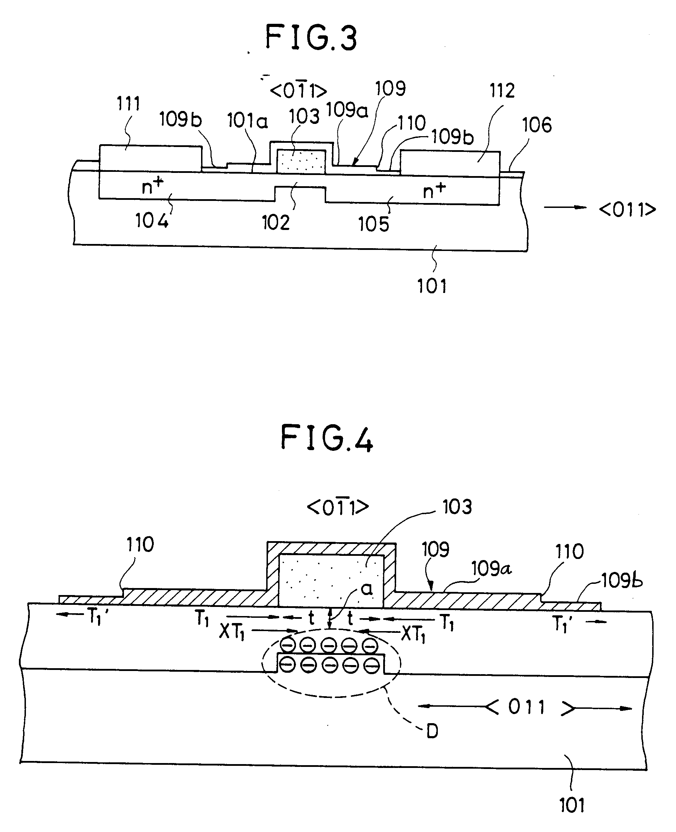

FIG.3 shows a first embodiment of the compound semiconductor field effect transistor of the present invention. Referring to FIG.3, the transistor comprises a semi-insulating GaAs substrate 101 defining a (100) surface 101a, a channel region 102 of the n-type defined in the substrate 101 by implantation of silicon ion (Si⁺) and elongating in an <011> direction of the GaAs substrate, a gate electrode 103 provided on the substrate 101 in contact therewith in correspondence to the channel region 102, a source region 104 of the n⁺-type defined in the substrate 101 on one side of the channel region 102, a drain region 105 also of the n⁺-type defined in the substrate 101 on the other side of the channel region 102, a silicon nitride protective film 106 covering the substrate 101 excluding those area in which the transistor is formed, a passivation film 109 of silicon nitride covering the gate electrode 103 as well as a part of the source region 104 and a part of the drain region 105 close to the gate electrode 103, a source electrode 111 of a stacked layers of Au-Ge alloy/Ni/Au and forming an ohmic contact with a part of the source region 104 not covered by the passivation film 109, and a drain electrode 102 also of a stacked layers of Au-Ge alloy/Ni/Au and forming an ohmic contact with a part of the drain region 105 not covered by the passivation film 109. Note that the gate electrode 103 extends in an <01̅1> direction of the GaAs substrate 101 in correspondence to the channel region 102. Thus, the general construction of the transistor is similar to that of the prior art transistor shown in FIG.1. As already noted with reference to the prior art device, the silicon nitride passivation film 109 experiences a compressional stress because of the difference in the temperature in which the device is fabricated and the temperature in which the device is used. The gate electrode 103 is made of a refractory metal silicide such as WSiₓ (x = 0.6), tungsten nitride WNₓ, tungsten W, or the like. The gate electrode made of these materials makes a Schottky contact with the substrate 101.

The transistor of the present embodiment, however, has a feature which distinguishes it over the prior art device in that the passivation film 109 has a reduced thickness at a marginal area 109b which is an area of the passivation film 109 in contact with the source electrode 111 or the drain electrode 112. In the present embodiment, the marginal area 109b is defined by a stepped part 110.

Next, the stress field and the piezoelectrical charge induced in the device of FIG.3 will be explained with reference to FIG.4. By reducing the thickness of the passivation film 109 at the marginal area 109b, the edge force applied to the substrate 101 at the marginal area by the compressional stress accumulated in the passivation film 109 is reduced and a tensile stress T₁′ corresponding to the stress T′ of FIG.2(A) is substantially reduced as shown in FIG.4 showing the distribution of the stress in the case of the device of FIG.3. As a result, the contribution of the tensile stress component originated by the stress T₁′ to the stress field under the gate electrode 103 is significantly reduced. In other words, a compressional stress acting in an <011> direction predominates a region D slightly below the gate electrode 103 including a lower part of the channel region 102, and there is induced a negative piezoelectric charge in the region D. Responsive thereto, the effective channel thickness a is reduced because of the negative charge formed in the channel region 102. More specifically, such a negative charge expels the electrons from the channel region 102 and forms a stationary depletion region under the gate electrode 103. Such a depletion region limits the channel thickness a and thereby the K-factor of the MESFET device indicating the operational speed of the device is increased. Thus, according to the present invention, one can reduce the size of the compound MESFET device without inviting decrease in the operational speed. In other words, one can increase the operational speed of the MESFET device by the miniaturization of the device without inducing the positive piezoelectric charge in the region under the gate electrode which causes undesirable decrease of the operational speed.

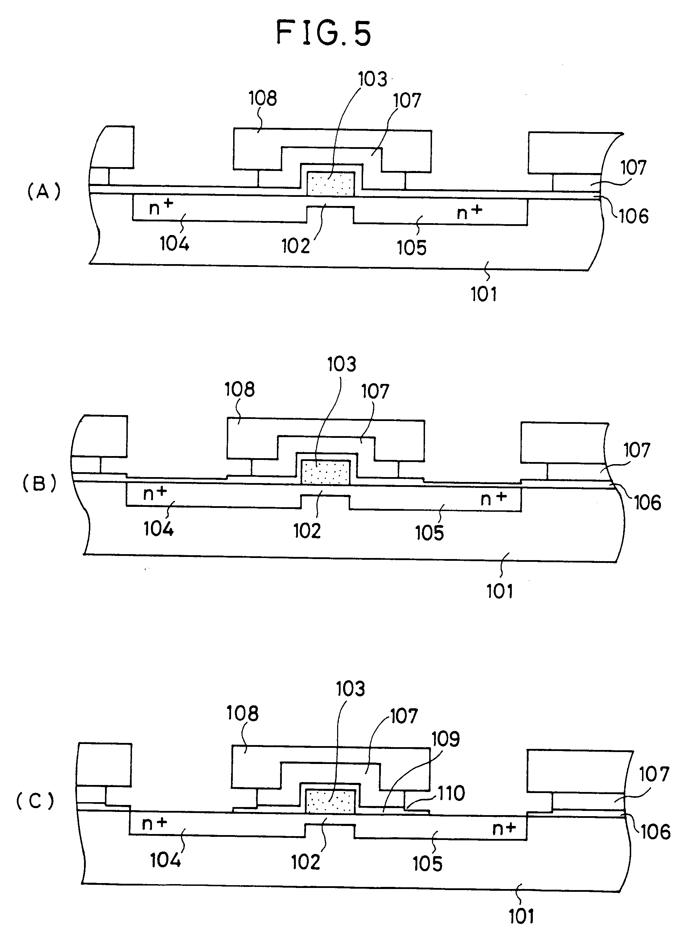

FIGS.5(A) - (C) show steps for manufacturing the structure of FIG.3. Referring to FIG.5(A), the semi-insulating GaAs substrate 101 is subjected to ion implantation of silicon (Si⁺) under an acceleration voltage of 30 keV with a dose of 2.5 X 10¹² cm⁻², whereby the channel region 102 is formed. Next, a tungsten silicide film is sputtered to cover the substrate 103 uniformly with a thickness of about 4500 Å 10 Å = 1 nm, and after patterning by dry etching, the gate electrode 103 having a gate length of 1 µm is formed. Next, the substrate 101 is again subjected to the ion implantation of Si⁺ under an acceleration voltage of 60 keV with a dose of 2 X 10¹³ cm⁻² while using the gate electrode 103 as a mask. Thereby, the source region 104 and the drain region 105 both doped to the n⁺-type are formed in alignment with the gate electrode 103. After this, the silicon nitride protective film 106 is deposited by plasma CVD so as to cover the entire structure with a thickness of about 1000 Å, and a silicon oxide film 107 is deposited further thereon with a thickness of about 5000 Å. Next, a photoresist 108 is deposited on the silicon oxide film 107 and after photolithographic patterning, a part of the silicon oxide film corresponding to the source region 104 and the drain region 105 is removed by wet etching using dilluted hydrofluoric acid. Thus, a structure shown in FIG.5(A) is obtained.

The structure of FIG.5(A) is then subjected to plasma etching using a mixture of carbon tetrafluoride (CF₄) and oxygen with a ratio of 20 : 1 and an electrical power of 200 watts under a pressure of 6.6 Pa (0.05 Torr), whereby the silicon nitride film 106 is etched anisotropically and a structure shown in FIG.5(B) is obtained in which the thickness of the silicon nitride film 106 is selectively reduced at the exposed part by a predetermined thickness in correspondence to the region of the substrate on which the source electrode or drain electrode is to be provided.

Next, the structure of FIG.5(B) is subjected again to plasma etching with a condition which causes an isotropic etching. For example, the etching may be performed by using the same gas mixture with a power of 100 watts and a pressure of 13.2 Pa (0.1 Torr). With this, the silicon nitride film 106 remaining in the structure of FIG.5(B) is uniformly removed until the part of the silicon nitride film 106 having the reduced thickness is disappeared. As a result, one obtains a structure shown in FIG.5(C) in which the passivation film 109 is separated from the silicon nitride film 106 and the step 110 is formed in the passivation film 109 at a boundary between a part which is subjected to the isotropic plasma etching and a part which was protected by the silicon oxide film 107 during the isotropic plasma etching.

After or before the removal of the photoresist 108 and the silicon oxide film 107, the source electrode 111 and the drain electrode 112 are provided according to a well known procedure with a thickness of about 4000 Å, and the structure of FIG.3 is obtained. In the illustrated example, the lateral thickness of the passivation film 109 at the side of the gate electrode 103 is 2000 Å, the thickness of the marginal area 109b of the passivation film is 300 Å, and the thickness of an inner area 109a of the passivation film 109 close to the gate electrode 103 is made to 1000 Å. Further, the separation between the gate electrode 103 and the source electrode 111 or the separation between the gate electrode 103 and the drain electrode 112 is set to 1 µm. It was found that the MESFET thus obtained has a threshold voltage Vₜₕ equal to zero volt and has an n_{g}-value of 0.5 which indicates the leak current passing through the substrate. This is a significant improvement over the prior art device in which the n_{g}-value was 5 and the Vₜₕ was -0.4 volts.

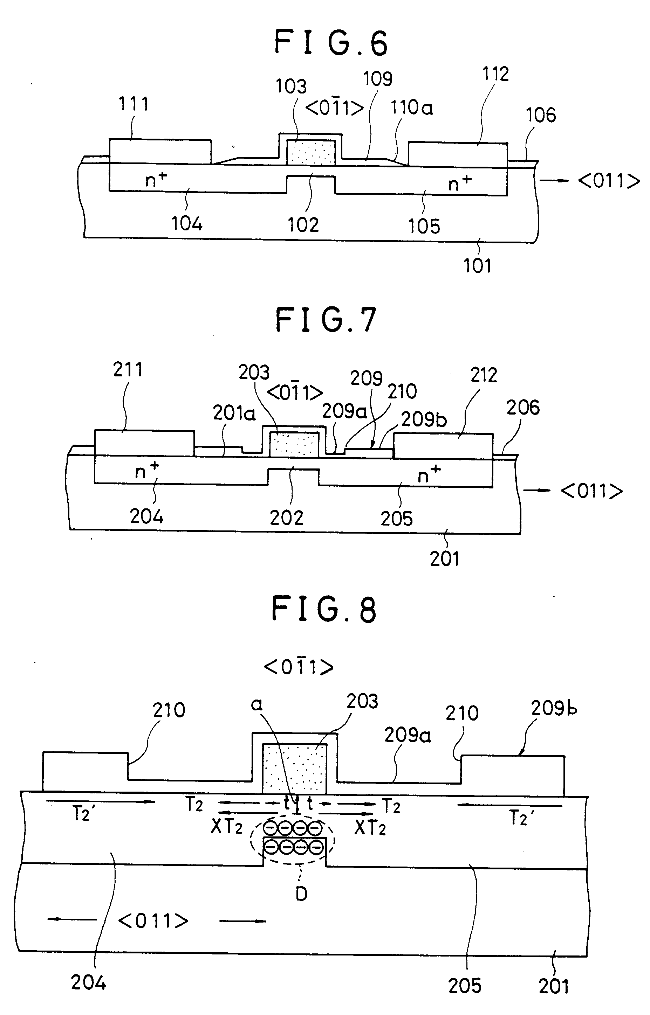

FIG.6 shows a modification of the MESFET device of FIG.3. In the drawing, these part having an identical construction with those parts in FIG.3 are given identical reference numerals and the description thereof will be omitted.

Referring to FIG.6, the marginal area of the silicon nitride passivation film 109 is thinned out gradually by a slope 110a. Such a slope may be formed by setting the etching condition at the etching step of FIG.5(B) for reducing the thickness of the marginal area such that the etching is made isotropically to some extent. In one example, the etching condition may be set such that the ratio of the carbon tetrafluoride gas and the oxygen gas is 20 : 1, the electrical power is 150 watts, and the pressure is 9.24 Pa (0.07 Torr). The marginal area thus thinned out provides a similar effect to reduce the tensile stress applied to the substrate 101 and the tensile stress component acting in the region D is substantially reduced even if the size of the transistor is reduced. Thus, one can suppress the formation of the undesirable positive piezoelectric charge in the channel region below the gate electrode and the operational speed of the device is improved similarly to the case of the device of FIG.3.

FIG.7 shows a second embodiment of the compound semiconductor field effect transistor of the present invention. Referring to FIG.7, the transistor comprises a semi-insulating GaAs substrate 201 defining a (100) surface 201a, a channel region 202 of the n-type defined in the substrate 201 by implantation of silicon ion (Si⁺) and extending in the <011> direction, a gate electrode 203 of WSiₓ (x = 0.6) and the like provided on the substrate 201 in contact therewith in correspondence to the channel region 202, a source region 204 of the n⁺-type defined in the substrate 201 on one side of the channel region 202, a drain region 205 also of the n⁺-type defined in the substrate 201 on the other side of the channel region 202, a silicon oxide (SiO₂) protective film 206 covering the substrate 201 excluding those area in which the transistor is formed, a passivation film 209 of silicon oxide covering the gate electrode 203 as well as a part of the source region 204 and a part of the drain region 205 close to the gate electrode 203, a source electrode 211 of a stacked layers of Au-Ge alloy/Ni/Au and forming an ohmic contact with a part of the source region 204 not covered by the passivation film 209, and a drain electrode 212 also of a stacked layers of Au-Ge alloy/Ni/Au and forming an ohmic contact with a part of the source region 205 not covered by the passivation film 209. Further, the gate electrode 203 extends in the <01̅1> direction with respect to the GaAs substrate 201 in correspondence to the channel region 202 as represented in the drawing. It should be noted that the silicon oxide passivation film 209 experiences a tensile stress because of the difference in the temperature at which the device is formed and the temperature at which the device is used as will be described with reference to FIG.8.

Further, the silicon oxide passivation film 209 has an increased thickness at a marginal area 209b which is an area of the passivation film 209 in contact with the source electrode 211 or the drain electrode 212 and a decreased thickness at an inner area 209a in a vicinity of the gate electrode 203. In the present embodiment, the marginal area 209b is defined by a stepped part 210.

As already noted with reference to the prior art device of FIG.2(B) in which the silicon oxide passivation film covers the gate electrode extending in the <01̅1> direction, there appears a large tensile stress stretching the substrate in the <011> direction at a region below the gate electrode. Such a tensile stress causes a positive piezoelectric charge in the substrate and deteriorates the operational speed of the device. By increasing the thickness of the passivation film 209 at the marginal area 209b, the edge force applied to the substrate 201 at the marginal area 209b of the passivation film 209 is increased and a compressive stress T₂′ corresponding to the stress T₀′, of FIG.2(B) is substantially increased as shown in FIG.8 showing the distribution of the stress in the case of the device of FIG.7. Further, by decreasing the thickness of the passivation film 209 at the area 209a adjacent to the gate electrode 203, the edge force applied to the substrate 201 by a tensile stress XT₂ corresponding to the tensile stress ΔT′ of FIG.2(B) is substantially reduced. As a result, the contribution of the compressive stress component originated by the stress T₂′ to the stress field under the gate electrode 203 is significantly increased. In other words, a compressional stress acting in the <011> direction predominates the region D slightly below the gate electrode 203 including a lower part of the channel region 202 particularly when the size of the MESFET device is decreased, and there is induced a negative piezoelectric charge in the region D effectively instead of the unwanted positive charge. Responsive thereto, the effective channel thickness a is reduced as such a negative charge expels the electrons from the channel region 102 and forms a stationary depletion region under the gate electrode 103. Such a depletion region limits the channel thickness a as already described and thereby the K-factor of the MESFET device indicating the operational speed of the device is increased. Thus, according to the present embodiment, one can increase the operational speed of the device by the piezoelectric effect associated with the miniaturization of the device additionally to the improvement of the operational speed of the device expected ordinarily by the miniaturization of the device.

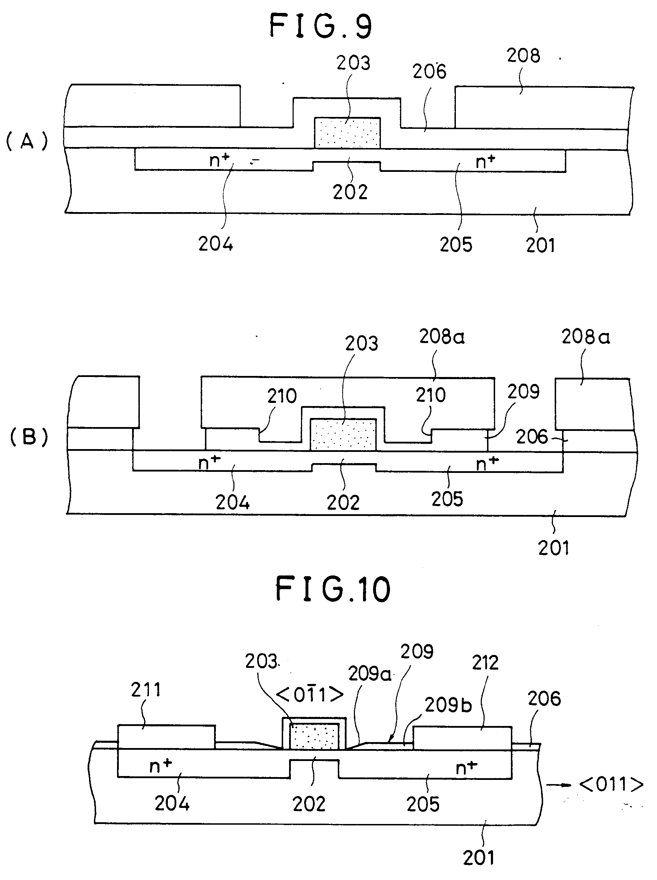

FIGS.9(A) and (B) show steps for manufacturing the structure of FIG.7. Referring to FIG.9(A), the semi-insulating GaAs substrate 201 is subjected to ion implantation of silicon (Si⁺) under an acceleration voltage of 30 keV with a dose of 2.5 X 10¹² cm⁻², whereby the channel region 202 is formed. Next, a tungsten silicide film is sputtered to cover the substrate 201 uniformly with a thickness of about 4500 Å, and after patterning by dry etching, the gate electrode 203 having a gate length of 1 µm is formed. Next, the substrate 201 is again subjected to the ion implantation of Si⁺ under an acceleration voltage of 60 keV with to a dose of 2 X 10¹³ cm⁻² while using the gate electrode 203 as a mask. Thereby, the source region 204 and the drain region 205 both doped to the n⁺-type are formed in alignment with the gate electrode 203. After this, a silicon oxide film 206 is deposited with a thickness of about 5000 Å. Next, a photoresist 208 is deposited on the silicon oxide film 206 and after photolithographic patterning for exposing a part of the silicon oxide film 206 corresponding to the region 209a as shown in FIG.9(A), the silicon oxide film 206 is etched away by dilluted hydrofluoric acid.

Next, the photoresist 208 is removed and the structure thus obtained is covered by another photoresist 208a exposing the region of the silicon oxide film 206 corresponding to the source electrode 211 and the drain electrode 212. After the plasma etching, the structure shown in FIG.9(B) is obtained in which the passivation film 209 is separated from the silicon oxide film 206 and from this, the structure of FIG.7 is obtained by removing the photoresist 208a and depositing the source electrode 211 and the drain electrode 212 according to the well known procedure for a thickness of about 4000 Å. In the illustrated example, the passivation film has a lateral thickness of 2000 Å at the side of the gate electrode 203 and a thickness of 300 Å at the region 209a adjacent to the gate electrode 203, while the thickness of the passivation film 209 at the marginal area 209b is set to 1000 Å. Further, the separation between the gate electrode 203 and the source electrode 211 or the separation between the gate electrode 203 and the drain electrode 212 is set to 1 µm similarly to the first embodiment. In this embodiment, too, a similar improvement of the operational speed of the MESFET device is achieved by the negative piezoelectric charge induced under the gate electrode 203. Further, a similar threshold voltage as well as the improvement in the n_{g}-factor as those of the first embodiment are obtained.

FIG.10. shows a modification of the MESFET device of FIG.7. In the drawing, these part having an identical construction with those parts in FIG.7 are given identical reference numerals and the description thereof will be omitted.

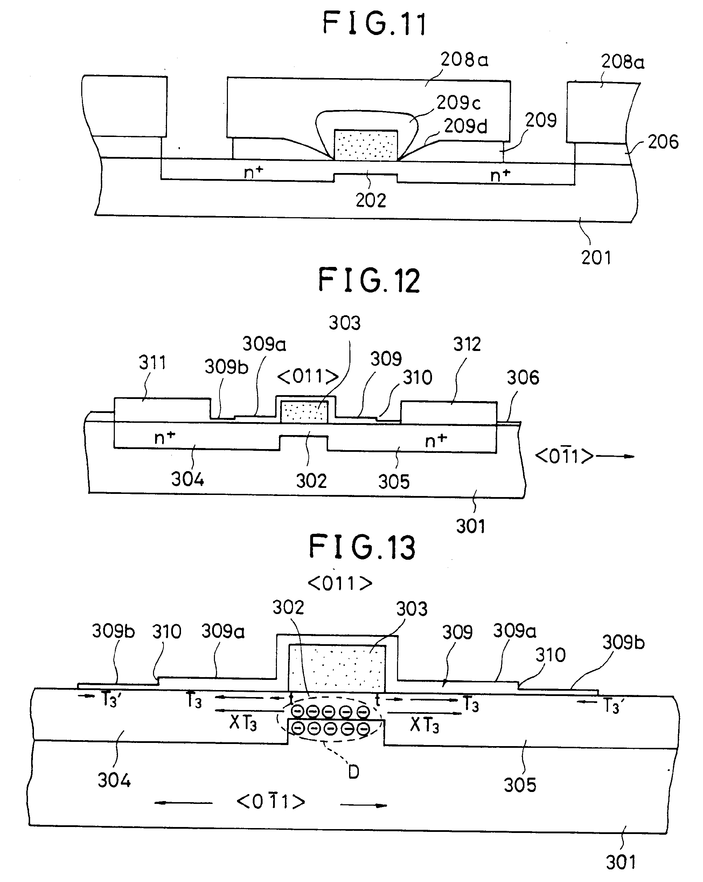

Referring to FIG.10, the inner area 109a of the silicon oxide passivation film 109 is thinned out gradually by a slope 110a declining towards the gate electrode 203. Such a slope may be formed at the time of depositing the silicon oxide film 206 by using an atmospheric pressure CVD method which deposits the silicon oxide according to a supply-limited kinetic process. FIG.11 shows such a silicon oxide passivation film 209 formed as a result of deposition of silicon oxide on the substrate 201 as well as on the gate electrode 203 by the atmospheric pressure CVD. Note that the passivation film 209 and the protective film 206 are already separated in FIG.11 by the etching corresponding to the source electrode 211 and the drain electrode 212. It can be seen that there is formed an overhang 209c of silicon oxide on the gate electrode 203 and in correspondence thereto, there is formed a slope 209d declining to the gate electrode 203 in the passivation film 209 on the substrate 201. The construction of the structure of FIG.11 from the structure of FIG.10 is straightforward and the description thereof will be omitted. It is obvious that the modification of FIG.10 also provides an improved operational speed by the negative piezoelectric charge induced under the gate electrode 203.

Next, a third embodiment of the MESFET device of the present invention will be described with reference to FIG.12. Referring to FIG.12, the device comprises a semi-insulating GaAs substrate 301 in which an n-type channel region 302 is defined so as to extend in the <01̅1> direction of the gallium arsenide substrate. Further, an n⁺-type source region 304 and an n⁺-type drain region 305 are defined in the substrate 301 at both sides of the channel region 302. On the substrate 301 corresponding to the channel region 302, a gate electrode 303 is provided along the <011> direction which is perpendicularly to the direction <01̅1> in which the gate electrode 103 or 203 of the previous embodiments has extended. Further, a gate electrode 311 and a drain electrode 312 are provided in correspondence to the source region 304 and the drain region 305 at a part relatively away from the gate electrode 303, and the part of the source region and the drain region not covered by the source electrode 311 or the drain electrode 312 are covered by a silicon oxide passivation film 309. In this embodiment, the passivation film 309 is divided into an inner area 309a and a marginal area 309b by a stepped part 310 in which the marginal area 309b has a reduced thickness relative to the inner area 309a. The procedure of manufacturing the device of the present embodiment will be omitted as such a procedure would be apparent to those skilled in the art from the previous description for manufacturing the device of FIG.3.

FIG.13 shows the stress field appearing in the substrate 301 of the device of FIG.12. As the passivation film 309 is made of silicon oxide, the passivation film experiences a tensile stress because of the difference in the temperature the device is fabricated and the temperature the device is used. Responsive thereto, the source region 304 and the drain region 305 experience a compressive stress and the channel region 302 located between the source region 304 and the drain region 305 is subjected to a large tensile stress T₃ acting to stretch the channel region 302. Further, the gate electrode 303 itself causes the tensile stress t as already described. On the other hand, the stress T₃′ at the marginal area 309b acting to the channel region 302 as a compressive stress has a only a small magnitude because of the reduced thickness of the marginal area 309b. Thus, there appears a large tensile stress component XT₃ in a region D of the substrate 301 slightly below the gate electrode 303. As the gate electrode 303 extends in the <011> direction, this tensile stress component XT₃ acts in the <01̅1> direction of the substrate which is perpendicular to the direction in which the stress component XT or XT′ of the previous embodiment has acted. The GaAs substrate 301 thus applied with the tensile stress in the <01̅1> direction induces a negative piezoelectric charge contrary to the previous embodiments and the operational speed of the MESFET is improved as a result of the limiting of the effective channel thickness a.

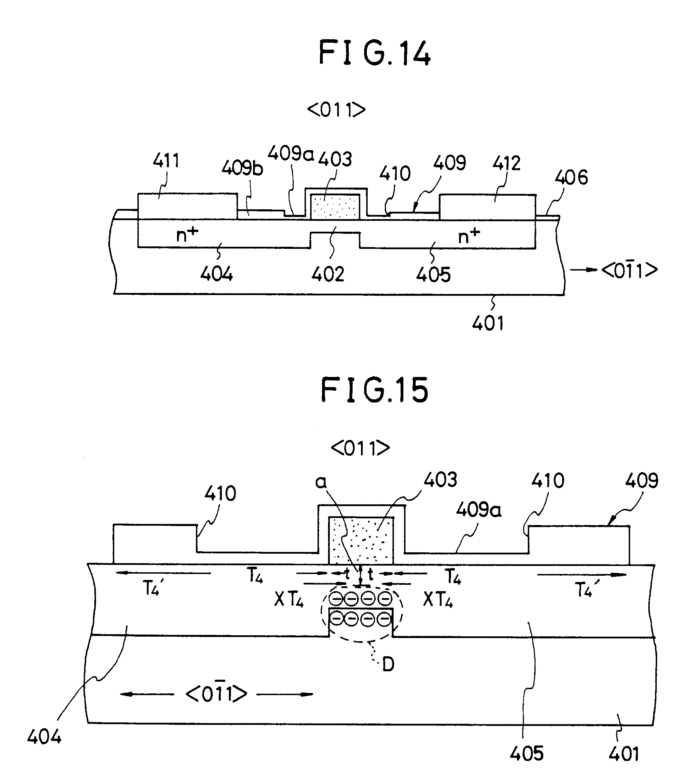

Next, a fourth embodiment of the MESFET device of the present invention will be described with reference to FIG.14. The device comprises a semi-insulating GaAs substrate 401 defined with an n-type channel region 402 extending in the <01̅1> direction of the substrate. Further, a source region 404 and a drain region 405 both doped to the n⁺-type are defined at both sides of the channel region 402 similarly to the device of FIG.12 and a gate electrode 403 is provided on the substrate 401 in correspondence to the channel region 402. Thus, the gate electrode 403 extends in the <011> direction similarly to the gate electrode 303. The source region 404 and the drain region 405 are provided with respective electrodes 411 and 412 making an ohmic contact therewith at a region away form the gate electrode 403 leaving an exposed region in a vicinity of the gate electrode 403 and this exposed region is covered by a silicon nitride passivation film 409 which is divided by a stepped part 410 into a first part 409a having a reduced thickness in a vicinity of the gate electrode 403 and a second part 409b having an increased thickness in a vicinity of the source or drain electrode 411, 412. The procedure for manufacturing the device of the present embodiment will be omitted as such a procedure would be apparent to those skilled in the art from the previous description for constructing the device of FIG.7.

As the silicon nitride passivation film 409 provided as such experiences a compressional stress similar to the silicon nitride passivation film in the previous embodiments, there appears tensile stresses T₄ and T₄′ acting to stretch the source region 404 or the drain region 405 as shown in FIG.15. As the thickness of the passivation film is thin in the part 409a in the vicinity of the gate electrode 403, the tensile stress T₄ acting under the part 409a is much smaller than the tensile stress T₄′ acting under the part 409b having a large thickness. Thus, the predominant stress field occuring in a region D slightly below the gate electrode 403 becomes tensile particularly when the size of the MESFET device is decreased, even though considering the stress component t caused by the gate electrode 403. As such a tensile stress acts in the <01̅1> direction of the GaAs substrate, there is induced a negative piezoelectric charge in the region D and the effective channel thickness a of the device is effectively limited. As a result, the increase in the operational speed of the device is facilitated similarly to the case of the second embodiment by the decrease in the size of the device in addition to the improvement of the operational speed ordinarily expected by such a miniaturization.

In the description heretofore, it was assumed that the substrate comprises GaAs which is a typical group III-V compound semiconductor material. However, the substrate is not limited to GaAs but any other group III-V semiconductor material such as InP having the zinc blende structure may be used, as a same piezoelectric effect occurs in such materials.

Further, the device of FIG.12 or 14 may be modified similarly to the device of FIG.6 or FIG.10 by gradually thinning out the marginal area 309b or the inner area 409a. Such a modification is obvious to those skilled in the art from the preceding description for the manufacturing of the structures of FIG.6 and FIG.10, and further description will be omitted.

Further, the present invention is not limited to these embodiments and modifications but various variations and modifications may te made without departing from the scope of the invention.

## Claims

1. A metal-semiconductor field effect transistor, comprising a substrate (101) of a group III-V compound semiconductor having a zinc blende structure, a gate electrode (103) provided on the substrate, a channel region (102) defined in the substrate in alignment with the gate electrode, a source region (104) defined in the substrate at one side of the channel region, a drain region (105) defined in the substrate at the other side of the channel region, a source electrode (111) provided on the substrate so as to cover a first part of the source region far from the gate electrode while leaving a second part of the source region close to the gate electrode uncovered, a drain electrode (112) provided on the substrate so as to cover a first part of the drain region far from the gate electrode while leaving a second part of the drain region close to the gate electrode uncovered, and a passivation film (109) provided so as to cover the gate electrode, said second part of the source region and said second part of the drain region, characterized in that said substrate has a (100)-oriented principal surface, said gate electrode (103) extends in an <01̅1> direction of the substrate (101), the channel region (102) extends in an <011> direction in correspondence to the gate electrode, said passivation film (109) comprises a material experiencing a compressive stress, said passivation film comprises a part provided to cover the gate electrode (103), an inner area part (109a), extending along said (100)-oriented principal surface, for covering a part of said second part of the source region close to the gate electrode and for covering a part of said second part of the drain region close to the gate electrode, and a marginal area part (109b) for covering a part of said second part of the source region far from the gate electrode and a part of said second part of the drain region far from the gate electrode, and that said marginal area part has a thickness substantially reduced relative to that of said inner area part.

2. A metal-semiconductor field effect transistor as claimed in claim 1 characterized in that said passivation film (109) comprises silicon nitride.

3. A metal-semiconductor field effect transistor as claimed in claim 1 or 2 characterized in that said marginal area part (109b) is defined relative to said inner area part by a stepped part (110) across which a thickness of the passivation film (109) changes stepwise.

4. A metal-semiconductor field effect transistor as claimed in claim 1 or 3 characterized in that said inner area part (109a) of the passivation film (109) has a thickness of about 1000 A and said marginal area (109b) part has a thickness of about 300 A.

5. A metal-semiconductor field effect transistor as claimed in claim lor 2 characterized in that said the thickness of the marginal area part (109b) is reduced gradually with increased distance from the gate electrode (103).

6. A metal-semiconductor field effect transistor, comprising a substrate (201) of a group III-V compound semiconductor having a zinc blende structure, a gate electrode (203) provided on the substrate, a channel region (202) defined in the substrate in alignment with the gate electrode, a source region (204) defined in the substrate at one side of the channel region, a drain region (205) defined in the substrate at the other side of the channel region, a source electrode (211) provided on the substrate so as to cover a first part of the source region far from the gate electrode while leaving a second part of the source region close to the gate electrode uncovered, a drain electrode (212) provided on the substrate so as to cover a first part of the drain region far from the gate electrode while leaving a second part of the drain region close to the gate electrode uncovered, and a passivation film (209) provided so as to cover the gate electrode, said second part of the source region and said second part of the drain region, characterized in that said substrate has a (100)-oriented principal surface, said gate electrode (203) extends in an <01̅1> direction of the substrate (201), the channel region (202) extends in an <011> direction in correspondence to the gate electrode, said passivation film (209) comprises a material experiencing a tensile stress, said passivation film comprises a part provided to cover said gate electrode (203), an inner area part (209a), extending along said (100)-oriented principal surface, for covering a part of said second part of the source region close to the gate electrode and for covering a part of said second part of the drain region close to the gate electrode, and a marginal area part (209b) for covering a part of said second part of the source region far from the gate electrode and a part of said second part of the drain region far from the gate electrode, and that said inner area part has a thickness substantially reduced relative to that of said marginal area part.

7. A metal-semiconductor field effect transistor as claimed in claim 6 characterized in that said passivation film (209) comprises silicon oxide.

8. A metal-semiconductor field effect transistor as claimed in claim 6 or 7 characterized in that said marginal area part (209b) is defined relative to said inner area part by a stepped part (210) across which a thickness of the passivation film changes stepwise.

9. A metal-semiconductor field effect transistor as claimed in claim 6 or 8 characterized in that said inner area part (209a) of the passivation film (209) has a thickness of about 300 A and said marginal area part (209b) of the passivation film has a thickness of about 1000 A.

10. A metal-semiconductor field effect transistor as claimed in claim 6 or7 characterized in that the thickness of the inner area part (209a) is reduced gradually towards the gate electrode (203).

11. A metal-semiconductor field effect transistor, comprising a substrate (301) of a group III-V compound semiconductor having a zinc blende structure, a gate electrode (303) provided on the substrate, a channel region (302) defined in the substrate in alignment with the gate electrode, a source region (304) defined in the substrate at one side of the channel region, a drain region (305) defined in the substrate at the other side of the channel region, a source electrode (311) provided on the substrate so as to cover a first part of the source region far from the gate electrode while leaving a second part of the source region close to the gate electrode uncovered, a drain electrode (312) provided on the substrate so as to cover a first part of the drain region far from the gate electrode while leaving a second part of the drain region close to the gate electrode uncovered, and a passivation film (309) provided so as to cover the gate electrode, said second part of the source region and said second part of the drain region, characterized in that said substrate has a (100)-oriented principal surface, said gate electrode (303) extends in an <011> direction of the substrate (301), the channel region (302) extends in an <01̅1> direction in correspondence to the gate electrode, said passivation film (309) comprises a material experiencing a tensile stress, said passivation film comprises a part provided to cover said gate electrode (303), an inner area part (309a), extending along said (100)-oriented principal surface, for covering a part of said second part of the source region close to the gate electrode and for covering a part of said second part of the drain region close to the gate electrode, and a marginal area part (309b) for covering a part of said second part of the source region far from the gate electrode and a part of said second part of the drain region far from the gate electrode, and that said marginal area part has a thickness substantially reduced relative to that of said inner area part.

12. A metal-semiconductor field effect transistor, comprising a substrate (401) of a group III-V compound semiconductor having a zinc blende structure, a gate electrode (403) provided on the substrate, a channel region (402) defined in the substrate in alignment with the gate electrode, a source region (404) defined in the substrate at one side of the channel region, a drain region (405) defined in the substrate at the other side of the channel region, a source electrode (411) provided on the substrate so as to cover a first part of the source region far from the gate electrode while leaving a second part of the source region close to the gate electrode uncovered, a drain electrode (412) provided on the substrate so as to cover a first part of the drain region far from the gate electrode while leaving a second part of the drain region close to the gate electrode uncovered, and a passivation film (409) provided so as to cover the gate electrode, said second part of the source region and said second part of the drain region, characterized in that said substrate has an (100)-oriented principal surface, said gate electrode (403) extends in an <011> direction of the substrate (401), the channel region (402) extends in an <01̅1> direction in correspondence to the gate electrode, said passivation film (409) comprises a material experiencing a compressive stress, said passivation film comprises a part provided to cover said gate electrode (403), an inner area part (409a), extending along said (100)-oriented principal surface, for covering a part of said second part of the source region close to the gate electrode and for covering a part of said second part of the drain region close to the gate electrode, and a marginal area part (409b) for covering a part of said second part of the source region far from the gate electrode and a part of said second part of the drain region far from the gate electrode, and that said inner area part has a thickness substantially reduced relative to that of said marginal area part.

## Patentansprüche

1. Metall-Halbleiter Feldeffekt-Transistor (MESFET) umfassend:
ein Substrat (101) eines III-V Halbleiters mit einem Zinkblenden-Aufbau, eine auf dem Substrat vorgesehenen Gate-Elektrode (103), ein im Substrat definiertes mit der Gate-Elektrode ausgerichtetes Kanalgebiet (102), ein im Substrat auf einer Seite des Kanalgebiets definiertes Sourcegebiet (104), ein im Substrat auf der anderen Seite des Kanalgebietes definiertes Draingebiet (105), eine auf dem Substrat vorgesehene Source-Elektrode (111), die einen von der Gate-Elektrode abliegenden ersten Bereich des Source-Gebiets überdeckt, während ein zweiter nahe der Gate-Elektrode liegender Bereich des Source-Gebiets unbedeckt bleibt, eine auf dem Substrat vorgesehene Drain-Elektrode (112), die einen von der Gate-Elektrode abliegenden ersten Bereich des Drain-Gebiets überdeckt, während ein zweiter nahe der Gate-Elektrode liegender Bereich des Drain-Gebiets unbedeckt bleibt, und ein Passivierungsfilm (109), der die Gate-Elektrode, den zweiten Bereich des Source-Gebiets und den zweiten Bereich des Drain-Gebiets überdeckt,
**dadurch gekennzeichnet**, daß das Substrat eine (100)-gerichtete Hauptoberfläche aufweist, die Gate-Elektrode (103) sich in <01̅1> Richtung des Substrats (101) erstreckt, das Kanalgebiet (102) sich in <011> Richtung entsprechend der Gate-Elektrode erstreckt, der Passivierungsfilm (109) ein Material besitzt, das eine Druckspannung erfährt, der Passivierungsfilm einen Bereich besitzt, der die Gate-Elektrode (103) überdeckt, einen inneren Flächenbereich (109a), der sich längs der (100)-gerichteten Hauptoberfläche erstreckt, um einen Teil des zweiten Bereichs des nahe der Gate-Elektrode liegenden Source-Gebiets zu überdecken, und um einen Teil des zweiten Bereichs des nahe der Gate-Elektrode liegenden Drain-Gebiets zu überdecken, und einen Randflächenbereich (109b) zum Abdecken eines Teils des zweiten Bereichs des von der Gate-Elektrode entfernt liegenden Source-Gebiets und eines Teils des zweiten Bereichs des von der Gate-Elektrode entfernt liegenden Drain-Gebiets, und daß der Randflächenbereich eine Dicke aufweist, die gegenüber derjenigen des inneren Flächenbereichs wesentlich reduziert ist.

2. Metall-Halbleiter Feldeffekt-Transistor nach Anspruch 1, dadurch gekennzeichnet, daß der Passivierungsfilm (109) Siliziumnitrid enthält.

3. Metall-Halbleiter Feldeffekt-Transistor nach Anspruch 1 oder 2, dadurch gekennzeichnet, daß der Randflächenbereich (109b) relativ zum inneren Flächenbereich durch eine abgesetzte Stufe (110) definiert ist, an der sich eine Dicke des Passivierungsfilms (109) schrittweise ändert.

4. Metall-Halbleiter Feldeffekt-Transistor nach Anspruch 1 oder 3, dadurch gekennzeichnet, daß der innere Flächenbereich (109a) des Passivierungsfilms (109) eine Dicke von etwa 1000 Å und der Randflächenbereich (109b) eine Dicke von etwa 300Å aufweist.

5. Metall-Halbleiter Feldeffekt-Transistor nach Anspruch 1 oder 2, dadurch gekennzeichnet, daß sich die Dicke des Randflächenbereichs (109b) mit zunehmendem Abstand von der Gate-Elektrode (103) allmählich verringert.

6. Metall-Halbleiter Feldeffekt-Transistor (MESFET) umfassend:
ein Substrat (201) eines III-V Halbleiters mit einem Zinkblenden-Aufbau, eine auf dem Substrat vorgesehenen Gate-Elektrode (203), ein im Substrat definiertes mit der Gate-Elektrode ausgerichtetes Kanalgebiet (202), ein im Substrat auf einer Seite des Kanalgebiets definiertes Sourcegebiet (204), ein im Substrat auf der anderen Seite des Kanalgebietes definiertes Draingebiet (205), eine auf dem Substrat vorgesehene Source-Elektrode (211), die einen von der Gate-Elektrode abliegenden ersten Bereich des Source-Gebiets überdeckt, während ein zweiter nahe der Gate-Elektrode liegender Bereich des Source-Gebiets unbedeckt bleibt, eine auf dem Substrat vorgesehene Drain-Elektrode (212), die einen von der Gate-Elektrode abliegenden ersten Bereich des Drain-Gebiets überdeckt, während ein zweiter nahe der Gate-Elektrode liegender Bereich des Drain-Gebiets unbedeckt bleibt, und ein Passivierungsfilm (209), der die Gate-Elektrode, den zweiten Bereich des Source-Gebiets und den zweiten Bereich des Drain-Gebiets überdeckt,
**dadurch gekennzeichnet**, daß das Substrat eine (100)-gerichtete Hauptoberfläche aufweist, die Gate-Elektrode (203) sich in <01̅1> Richtung des Substrats (201) erstreckt, das Kanalgebiet (202) sich in <011> Richtung entsprechend der Gate-Elektrode erstreckt, der Passivierungsfilm (209) ein Material besitzt, das eine Zugspannung erfährt, der Passivierungsfilm einen Bereich besitzt, der die Gate-Elektrode (203) überdeckt, einen inneren Flächenbereich (209a), der sich längs der (100)-gerichteten Hauptoberfläche erstreckt, um einen Teil des zweiten Bereichs des nahe der Gate-Elektrode liegenden Source-Gebiets zu überdecken, und um einen Teil des zweiten Bereichs des nahe der Gate-Elektrode liegenden Drain-Gebiets zu überdecken, und einen Randflächenbereich (209b) zum Abdecken eines Teils des zweiten Bereichs des von der Gate-Elektrode entfernt liegenden Source-Gebiets und eines Teils des zweiten Bereichs des von der Gate-Elektrode entfernt liegenden Drain-Gebiets, und daß der Randflächenbereich eine Dicke aufweist, die gegenüber derjenigen des inneren Flächenbereichs wesentlich reduziert ist.

7. Metall-Halbleiter Feldeffekt-Transistor nach Anspruch 6, dadurch gekennzeichnet, daß der Passivierungsfilm (209) Siliziumoxid enthält.

8. Metall-Halbleiter Feldeffekt-Transistor nach Anspruch 6 oder 7, dadurch gekennzeichnet, daß der Randflächenbereich (209b) relativ zum inneren Flächenbereich durch eine abgesetzte Stufe (210) definiert ist, an der sich eine Dicke des Passivierungsfilms schrittweise ändert.

9. Metall-Halbleiter Feldeffekt-Transistor nach Anspruch 6 oder 7, dadurch gekennzeichnet, daß der innere Flächenbereich (209a) des Passivierungsfilms (209) eine Dicke von etwa 300 Å und der Randflächenbereich (209b) eine Dicke von etwa 1000Å aufweist.

10. Metall-Halbleiter Feldeffekt-Transistor nach Anspruch 6 oder 7, dadurch gekennzeichnet, daß sich die Dicke des inneren Flächenbereichs (209a) mit zunehmendem Abstand von der Gate-Elektrode (203) allmählich verringert.

11. Metall-Halbleiter Feldeffekt-Transistor (MESFET) umfassend:
ein Substrat (301) eines III-V Halbleiters mit einem Zinkblenden-Aufbau, eine auf dem Substrat vorgesehene Gate-Elektrode (303), ein im Substrat definiertes mit der Gate-Elektrode ausgerichtetes Kanalgebiet (302), ein im Substrat auf einer Seite des Kanalgebiets definiertes Sourcegebiet (304), ein im Substrat auf der anderen Seite des Kanalgebietes definiertes Draingebiet (305), eine auf dem Substrat vorgesehene Source-Elektrode (311), die einen von der Gate-Elektrode abliegenden ersten Bereich des Source-Gebiets überdeckt, während ein zweiter nahe der Gate-Elektrode liegender Bereich des Source-Gebiets unbedeckt bleibt, eine auf dem Substrat vorgesehene Drain-Elektrode (312), die einen von der Gate-Elektrode abliegenden ersten Bereich des Drain-Gebiets überdeckt, während ein zweiter nahe der Gate-Elektrode liegender Bereich des Drain-Gebiets unbedeckt bleibt, und ein Passivierungsfilm (309), der die Gate-Elektrode, den zweiten Bereich des Source-Gebiets und den zweiten Bereich des Drain-Gebiets überdeckt,
**dadurch gekennzeichnet**, daß das Substrat eine (100)-gerichtete Hauptoberfläche aufweist, die Gate-Elektrode (303) sich in <011> Richtung des Substrats (301) erstreckt, das Kanalgebiet (302) sich in <01̅1> Richtung entsprechend der Gate-Elektrode erstreckt, der Passivierungsfilm (309) ein Material besitzt, das eine Zugspannung erfährt, der Passivierungsfilm einen Bereich besitzt, der die Gate-Elektrode (303) überdeckt, einen inneren Flächenbereich (309a), der sich längs der (100)-gerichteten Hauptoberfläche erstreckt, um einen Teil des zweiten Bereichs des nahe der Gate-Elektrode liegenden Source-Gebiets zu überdecken, und um einen Teil des zweiten Bereichs des nahe der GateElektrode liegenden Drain-Gebiets zu überdecken, und einen Randflächenbereich (309b) zum Abdecken eines Teils des zweiten Bereichs des von der Gate-Elektrode entfernt liegenden Source-Gebiets und eines Teils des zweiten Bereichs des von der Gate-Elektrode entfernt liegenden Drain-Gebiets, und daß der Randflächenbereich eine Dicke aufweist, die gegenüber derjenigen des inneren Flächenbereichs wesentlich reduziert ist.

12. Metall-Halbleiter Feldeffekt-Transistor (MESFET) umfassend:
ein Substrat (401) eines III-V Halbleiters mit einem Zinkblenden-Aufbau, eine auf dem Substrat vorgesehenen Gate-Elektrode (403), ein im Substrat definiertes mit der Gate-Elektrode ausgerichtetes Kanalgebiet (402), ein im Substrat auf einer Seite des Kanalgebiets definiertes Sourcegebiet (404), ein im Substrat auf der anderen Seite des Kanalgebietes definiertes Draingebiet (405), eine auf dem Substrat vorgesehene Source-Elektrode (411), die einen von der Gate-Elektrode abliegenden ersten Bereich des Source-Gebiets überdeckt, während ein zweiter nahe der Gate-Elektrode liegender Bereich des Source-Gebiets unbedeckt bleibt, eine auf dem Substrat vorgesehene Drain-Elektrode (412), die einen von der Gate-Elektrode abliegenden ersten Bereich des Drain-Gebiets überdeckt, während ein zweiter nahe der Gate-Elektrode liegender Bereich des Drain-Gebiets unbedeckt bleibt, und ein Passivierungsfilm (409), der die Gate-Elektrode, den zweiten Bereichs des Source-Gebiets und den zweiten Bereich des Drain-Gebiets überdeckt,
**dadurch gekennzeichnet**, daß das Substrat eine (100)-gerichtete Hauptoberfläche aufweist, die Gate-Elektrode (403) sich in <011> Richtung des Substrats (401) erstreckt, das Kanalgebiet (402) sich in <01̅1> Richtung entsprechend der Gate-Elektrode erstreckt, der Passivierungsfilm (409) ein Material besitzt, das eine Druckspannung erfährt, der Passivierungsfilm einen Bereich besitzt, der die Gate-Elektrode (403) überdeckt, einen inneren Flächenbereich (409a), der sich längs der (100)-gerichteten Hauptoberfläche erstreckt, um einen Teil des zweiten Bereichs des nahe der Gate-Elektrode liegenden Source-Gebiets zu überdecken, und um einen Teil des zweiten Bereichs des nahe der Gate-Elektrode liegenden Drain-Gebiets zu überdecken, und einen Randflächenbereich (409b) zum Abdecken eines Teils des zweiten Bereichs des von der Gate-Elektrode entfernt liegenden Source-Gebiets und eines Teils des zweiten Bereichs des von der Gate-Elektrode entfernt liegenden Drain-Gebiets, und daß der Randflächenbereich eine Dicke aufweist, die gegenüber derjenigen des inneren Flächenbereichs wesentlich reduziert ist.

## Revendications

1. Transistor à effet de champ métal-semiconducteur comprenant un substrat (101) en un semiconducteur composite du groupe III-V comportant une structure de blende, une électrode de grille (103) prévue sur le substrat, une région de canal (102) définie dans le substrat en alignement avec l'électrode de grille, une région de source (104) définie dans le substrat au niveau d'un côté de la région de canal, une région de drain (105) définie dans le substrat au niveau de l'autre côté de la région de canal, une électrode de source (111) prévue sur le substrat de manière à recouvrir une première partie de la région de source éloignée de l'électrode de grille tout en laissant une seconde partie de la région de source proche de l'électrode de grille non recouverte, une électrode de drain (112) prévue sur le substrat de manière à recouvrir une première partie de la région de drain éloignée de l'électrode de grille tout en laissant une seconde partie de la région de drain proche de l'électrode de grille non recouverte et un film de passivation (109) prévu de manière à recouvrir l'électrode de grille, ladite seconde partie de la région de source et ladite seconde partie de la région de drain, caractérisé en ce que ledit substrat présente une surface principale orientée <100>, ladite électrode de grille (103) s'étend suivant une direction <01̅1> du substrat (101), la région de canal (102) s'étend suivant une direction <011> en correspondance avec l'électrode de grille, ledit film de passivation (109) comprend un matériau qui subit une contrainte de compression, ledit film de passivation comprend une partie prévue de manière à recouvrir l'électrode de grille (103), une partie de zone interne (109a) s'étendant suivant ladite surface principale orientée <100> pour recouvrir une partie de ladite seconde partie de la région de source proche de l'électrode de grille et pour recouvrir une partie de ladite seconde partie de la région de drain proche de l'électrode de grille, et une partie de zone marginale (109b) pour recouvrir une partie de ladite seconde partie de la région de source éloignée de l'électrode de grille et une partie de ladite seconde partie de la région de drain éloignée de l'électrode de grille, et en ce que ladite partie de zone marginale présente une épaisseur sensiblement réduite par rapport à celle de ladite partie de zone interne.

2. Transistor à effet de champ métal-semiconducteur selon la revendication 1, caractérisé en ce que ledit film de passivation (109) comprend du nitrure de silicium.

3. Transistor à effet de champ métal-semiconducteur selon la revendication 1 ou 2, caractérisé en ce que ladite partie de zone marginale (109b) est définie par rapport à ladite partie de zone interne par une partie étagée (110) sur laquelle une épaisseur du film de passivation (109) varie par pas.

4. Transistor à effet de champ métal-semiconducteur selon la revendication 1 ou 3, caractérisé en ce que ladite partie de zone interne (109a) du film de passivation (109) présente une épaisseur d'environ 1000 Å et ladite partie de zone marginale (109b) présente une épaisseur d'environ 300 Å.

5. Transistor à effet de champ métal-semiconducteur selon la revendication 1 ou 2, caractérisé en ce que ladite épaisseur de la partie de zone marginale (109b) est réduite progressivement lorsque la distance par rapport à l'électrode de grille (103) croît.

6. Transistor à effet de champ métal-semiconducteur comprenant un substrat (201) en un semiconducteur composite du groupe III-V comportant une structure de blende, une électrode de grille (203) prévue sur le substrat, une région de canal (202) définie dans le substrat en alignement avec l'électrode de grille, une région de source (204) définie dans le substrat au niveau d'un côté de la région de canal, une région de drain (205) définie dans le substrat au niveau de l'autre côté de la région de canal, une électrode de source (211) prévue sur le substrat de manière à recouvrir une première partie de la région de source éloignée de l'électrode de grille tout en laissant une seconde partie de la région de source proche de l'électrode de grille non recouverte, une électrode de drain (212) prévue sur le substrat de manière à recouvrir une première partie de la région de drain éloignée de l'électrode de grille tout en laissant une seconde partie de la région de drain proche de l'électrode de grille non recouverte, et un film de passivation (209) prévu de manière à recouvrir l'électrode de grille, ladite seconde partie de la région de source et ladite seconde partie de la région de drain, caractérisé en ce que ledit substrat comporte une surface principale orientée <100>, ladite électrode de grille (203) s'étend suivant une direction <01̅1> du substrat (201), la région de canal (202) s'étend suivant une direction <011> en correspondance avec l'électrode de grille, ledit film de passivation (209) comprend un matériau qui subit une contrainte de traction, ledit film de passivation comprend une partie prévue de manière à recouvrir ladite électrode de grille (203), une partie de zone interne (209a) qui s'étend suivant ladite surface principale orientée <100> pour recouvrir une partie de ladite seconde partie de la région de source proche de l'électrode de grille et pour recouvrir une partie de ladite seconde partie de la région de drain proche de l'électrode de grille, et une partie de zone marginale (209b) pour recouvrir une partie de ladite seconde partie de la région de source éloignée de l'électrode de grille et une partie de ladite seconde partie de la région de drain éloignée de l'électrode de grille, et en ce que ladite partie de zone interne présente une épaisseur sensiblement réduite par rapport à celle de ladite partie de zone marginale.

7. Transistor à effet de champ métal-semiconducteur selon la revendication 6, caractérisé en ce que ledit film de passivation (209) comprend de l'oxyde de silicium.

8. Transistor à effet de champ métal-semiconducteur selon la revendication 6 ou 7, caractérisé en ce que ladite partie de zone marginale (209b) est définie par rapport à ladite partie de zone interne par une partie étagée (210) sur laquelle une épaisseur du film de passivation varie par pas.

9. Transistor à effet de champ métal-semiconducteur selon la revendication 6 ou 8, caractérisé en ce que ladite partie de zone interne (209a) du film de passivation (209) présente une épaisseur d'environ 300 Å et ladite partie de zone marginale (209b) du film de passivation présente une épaisseur d'environ 1000 Å.

10. Transistor à effet de champ métal-semiconducteur selon la revendication 6 ou 7, caractérisé en ce que l'épaisseur de ladite partie de zone interne (209a) est réduite progressivement lorsqu'on se rapproche de l'électrode de grille (203).

11. Transistor à effet de champ métal-semiconducteur comprenant un substrat (301) en un semiconducteur composite du groupe III-V comportant une structure de blende, une électrode de grille (303) prévue sur le substrat, une région de canal (302) définie dans le substrat en alignement avec l'électrode de grille, une région de source (304) définie dans le substrat au niveau d'un côté de la région de canal, une région de drain (305) définie dans le substrat au niveau de l'autre côté de la région de canal, une électrode de source (311) prévue sur le substrat de manière à recouvrir une première partie de la région de source éloignée de l'électrode de grille tout en laissant une seconde partie de la région de source proche de l'électrode de grille non recouverte, une électrode de drain (312) prévue sur le substrat de manière à recouvrir une première partie de la région de drain éloignée de l'électrode de grille tout en laissant une seconde partie de la région de drain proche de l'électrode de grille non recouverte, et un film de passivation (309) prévu de manière à recouvrir l'électrode de grille, ladite seconde partie de la région de source et ladite seconde partie de la région de drain, caractérisé en ce que ledit substrat comporte une surface principale orientée <100>, ladite électrode de grille (303) s'étend suivant une direction <011> du substrat (301), la région de canal (302) s'étend suivant une direction <01̅1> en correspondance avec l'électrode de grille, ledit film de passivation (309) comprend un matériau qui subit une contrainte de traction, ledit film de passivation comprend une partie prévue de manière à recouvrir ladite électrode de grille (303), une partie de zone interne (309a) s'étendant suivant ladite surface principale orientée <100> pour recouvrir une partie de ladite seconde partie de la région de source proche de l'électrode de grille et pour recouvrir une partie de ladite seconde partie de la région de drain proche de l'électrode de grille, et une partie de zone marginale (309b) pour recouvrir une partie de ladite seconde partie de la région de source éloignée de l'électrode de grille et une partie de ladite seconde partie de la région de drain éloignée de l'électrode de grille, et en ce que ladite partie de zone marginale présente une épaisseur sensiblement réduite par rapport à celle de ladite partie de zone interne.

12. Transistor à effet de champ métal-semiconducteur, comprenant un substrat (401) en un semiconducteur composite du groupe III-V comportant une structure de blende, une électrode de grille (403) prévue sur le substrat, une région de canal (402) définie dans le substrat en alignement avec l'électrode de grille, une région de source (404) définie dans le substrat au niveau d'un côté de la région de canal, une région de drain (405) définie dans le substrat au niveau de l'autre côté de la région de canal, une électrode de source (411) prévue sur le substrat de manière à recouvrir une première partie de la région de source éloignée de l'électrode de grille tout en laissant une seconde partie de la région de source proche de l'électrode de grille non recouverte, une électrode de drain (412) prévue sur le substrat de manière à recouvrir une première partie de la région de drain éloignée de l'électrode de grille tout en laissant une seconde partie de la région de drain proche de l'électrode de grille non recouverte, et un film de passivation (409) prévu de manière à recouvrir l'électrode de grille, ladite seconde partie de la région de source et ladite seconde partie de la région de drain, caractérisé en ce que ledit substrat comporte une surface principale orientée <100>, ladite électrode de grille (403) s'étend suivant une direction <011> du substrat (401), la région de canal (402) s'étend suivant une direction <01̅1> en correspondance avec l'électrode de grille, ledit film de passivation (409) comprend un matériau qui subit une contrainte de compression, ledit film de passivation comprend une partie prévue de manière à recouvrir ladite électrode de grille (403), une partie de zone interne (409a) s'étendant suivant ladite surface principale orientée <100> pour recouvrir une partie de ladite seconde partie de la région de source proche de l'électrode de grille et pour recouvrir une partie de ladite seconde partie de la région de drain proche de l'électrode de grille, et une partie de zone marginale (409b) pour recouvrir une partie de ladite seconde partie de la région de source éloignée de l'électrode de grille et une partie de ladite seconde partie de la région de drain éloignée de l'électrode de grille, et en ce que ladite partie de zone interne présente une épaisseur sensiblement réduite par rapport à celle de ladite partie de zone marginale.
